# EUROPÄISCHE PATENTSCHRIFT

(11) **EP 1 397 948 B1**
(45) Veröffentlichungstag und Bekanntmachung des Hinweises auf die Patenterteilung: **17.08.2005**
(21) Anmeldenummer: 02750785.4
(22) Anmeldetag: 12.06.2002
(51) Int. Cl.: H05K 13/04

(54) **AUFSETZVORRICHTUNG UND VERFAHREN ZUM AUFSETZEN VON OBJEKTEN AUF SUBSTRATE**
PLACING DEVICE AND METHOD FOR PLACING OBJECTS ONTO SUBSTRATES
DISPOSITIF DE MISE EN PLACE ET PROCEDE POUR METTRE DES OBJETS EN PLACE SUR DES SUBSTRATS

(30) Priorität: 19.06.2001 DE 10129352
(43) Veröffentlichungstag der Anmeldung: 17.03.2004
(73) Patentinhaber: SIEMENS AKTIENGESELLSCHAFT, 80333 München (DE)
(72) Erfinder: DÜBEL, Rainer, 85598 Baldham (DE)
(86) Internationale Anmeldenummer: PCT/DE2002/002152
(87) Internationale Veröffentlichungsnummer: WO 2002/104091

(56) Entgegenhaltungen:
- DE-A- 3 938 088
- JP-A- 5 082 998
- US-A- 4 705 311
- US-A- 5 447 266
- US-A- 5 783 915

## Beschreibung

Die Erfindung betrifft eine Aufsetzvorrichtung und ein Verfahren zum Aufsetzen von Objekten auf Substrate, wobei ein Greifer an einem Halter bewegbar angeordnet ist, welcher zum Aufsetzen der Objekte auf die Substrate auf die Substrate zu bewegbar ist. Zwischen dem Greifer und dem Halter ist eine Spiralfeder derart angeordnet, dass beim Aufsetzen des Greifers dieser relativ zu dem Halter gegen die Federkraft der Feder bewegt wird. Hierdurch ist eine vorbestimmte Kraft als Aufsetzkraft der Objekte auf die Substrate vorgegeben.

Hierbei besteht jedoch der Nachteil, dass eine variable Kraftsteuerung der Aufsetzkraft nur mittels Bestimmen jener Kraft, mit welcher der Halter auf das Substrat zu bewegt wird, möglich ist. Herkömmliche Antriebe für derartige Halter sowie auch die Halter weisen jedoch große Massen und daher hohe Massenträgheit auf. Das Aufsetzen erfolgt daher nicht mit der durch die Feder vorbestimmten Aufsetzkraft sondern mit einer deutlich höheren Kraft, welche auf das Objekt und somit auf das Substrat einwirkt. Neben der Massenträgheit des Halters, des Greifers und des Antriebs des Halters wirkt sich hier auch das Trägheitsmoment des Antriebs des Halters negativ aus.

Insbesondere beim Bestücken von elektrischen Bauelementen auf Substrate ist es angesichts der zunehmenden Miniaturisierung der Bauelemente erforderlich, geringe Aufsetzkräfte der Bauelemente auf die Substrate mit hoher Genauigkeit zur Verfügung zu stellen. Dies ist mit der herkömmlichen Vorrichtung und dem herkömmlichen Verfahren nicht möglich.

Der Erfindung liegt daher die Aufgabe zugrunde, eine Aufsetzvorrichtung und ein Verfahren zum Aufsetzen von Objekten auf Substrate anzugeben, mittels welchen sehr geringe Aufsetzkräfte mit hoher Genauigkeit erreichbar sind.

Die Aufgabe wird gelöst durch eine Aufsetzvorrichtung mit den Merkmalen nach Anspruch 1 und ein Verfahren mit den Merkmalen nach Anspruch 10. Bevorzugte Ausgestaltungen der Erfindung sind in den abhängigen Ansprüchen beansprucht.

Durch die erfindungsgemäße Aufsetzvorrichtung nach Anspruch 1 ist es möglich, mittels eines elektrischen, eines magnetischen und/oder eines elektromagnetischen Feldes eine steuerbare Kraftwirkung zwischen einem Halter und einem an dem Halter bewegbar geführten Greifer zu erreichen. Durch Steuern der Größe des Feldes ist es möglich, die Kraft sehr genau vorzubestimmen. Die vorbestimmte Aufsetzkraft ist dabei auch unabhängig von dem Weg, welcher beim Aufsetzen der Objekte auf die Substrate von dem Greifer relativ zu dem Halter zurückgelegt wird.

Die steuerbare Kraftwirkung ermöglicht, dass die Aufsetzkraft weitgehend unabhängig von Trägheitseffekten der Aufsatzvorrichtung ist. Beim Aufsetzen wirkt sich ausschließlich die Massenträgheit des Greifers auf die Aufsetzkraft aus. Die Massenträgheit des Halters und der restlichen Aufsetzvorrichtung wirkt sich nicht auf die Aufsetzkraft aus.

Durch die Weiterbildungen nach den Ansprüchen 2 bis 4 sind unterschiedliche Ausgestaltungen der Erfindung aufgezeigt. Es ist hierbei möglich, zur Erzeugung der Kraftwirkung durch ein Feld zwischen dem Greifer und dem Halter einer Aufsetzvorrichtung Elektromagnete und/oder Permanentmagnete als Koppelelemente zu verwenden, welche jeweils miteinander wechselwirken. Mindestens eines der erfindungsgemäß vorgesehenen Koppelelemente ist dabei ein Elektromagnet, beispielsweise eine von einem elektrischen Strom durchflossene Spule. Durch Steuern des die Spule durchfließenden Stroms ist unmittelbar die Aufsetzkraft des Objekts auf das Substrat steuerbar.

Falls an dem Greifer das entsprechende Koppelelement als Elektromagnet ausgebildet ist, ist es ferner möglich, eine noch geringere Masse des Greifers zu erreichen. Hierdurch werden Kraftspitzen der Aufsetzkraft effektiv verhindert.

Ferner ist es hierdurch möglich, den Kraftverlauf nicht lediglich statisch sondern dynamisch entsprechend eines gewünschten und vorgegebenen Kraftverlaufs zu steuern.

Ferner kann zwischen einer Führungsvorrichtung des Greifers, welche den Greifer an dem Halter führt, und Anschlagstücken, welche an dem Halter vorgesehen sind, jeweils ein Dämpfelement angeordnet werden. Vor dem Aufsetzen eines Objekts auf ein Substrat kann hiermit beispielsweise der Greifer mittels der beiden Koppelelemente derart gegen eines der Dämpfelemente vorgespannt werden, dass die Aufsetzkraft bzw. der Verlauf der Aufsetzkraft lediglich durch die Charakteristik des Dämpfelements bestimmt ist.

Bei dem erfindungsgemäßen Verfahren zum Aufsetzen eines Greifers auf Objekte auf einem Substrat ist es möglich, den Verlauf der Aufsetzkraft während des Aufsetzens des Objekts auf das Substrat sowohl entsprechend statischen als auch dynamischen zeitlichen Verläufen der Aufsetzkraft vorher zu bestimmen. Durch Steuern des magnetischen und/oder elektrischen Feldes, mittels welchem eine die Aufsetzkraft bestimmende Kraftwirkung zwischen dem Halter und dem Greifer erreicht wird, sind über einen großen Kraftbereich variable Aufsetzkräfte möglich.

Durch das erfindungsgemäße Verfahren ist es sowohl möglich, beim Aufsetzen von Objekten auf Substrate vorbestimmte Aufsatzkräfte zu erreichen, als auch beim Abheben von Objekten von Substraten die Beschleunigungsspitzen, welche auf das Objekt wirken, effektiv zu reduzieren. Hierzu wird vor dem Abheben von Objekten von den Substraten der Greifer auf den Halter zu bewegt. In dieser Stellung wird der komplette Halter mitsamt des Greifers auf das Objekt auf dem Substrat abgesenkt und mittels des Greifers das Objekt von dem Substrat abgehoben. Während des Abhebens wird der Greifer relativ zu dem Halter entgegen der Abheberichtung bewegt. Hierdurch wird die Beschleunigung beim Abheben des Objekts von dem Substrat verringert.

Die Erfindung wird unter Bezugnahme auf die Zeichnung näher erläutert. In der Zeichnung zeigen:
Figur 1 eine schematische Ansicht der erfindungsgemäßen Aufsetzvorrichtung mit an einem Anschlagstück angelegtem Greifer in einer ersten Vorspann-Stellung,
Figur 2 eine schematische Ansicht der erfindungsgemäßen Aufsetzvorrichtung mit in einer Zwischenposition befindlichem Greifer und
Figur 3 eine schematische Ansicht der erfindungsgemäßen Aufsetzvorrichtung mit an einem anderen Anschlagstück angelegtem Greifer in einer zweiten Vorspann-Stellung.

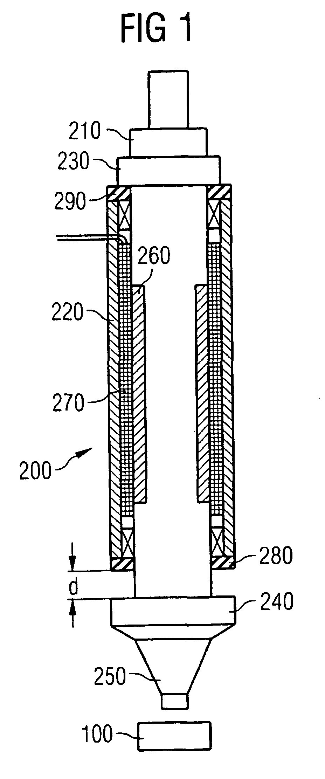

Wie aus Figur 1 ersichtlich, weist eine erfindungsgemäße Aufsetzvorrichtung 200 einen Halter 220 und einen entlang des Halters in einer Aufsetzrichtung A bewegbaren Greifer 241 auf. An dem Greifer 210 ist beispielsweise eine Vakuumpipette 250 zum Halten von Objekten 100 angeordnet. Der Greifer 210 ist derart an dem Halter 220 gelagert, dass der Greifer 210 in der Aufsetzrichtung A von dem Halter 220 vorragt.

An dem Greifer 210 sind zwei Anschlagstücke 230 und 240 angeordnet. Der Greifer 210 ist relativ zu dem Halter 220 in der Aufsetzrichtung A zwischen den beiden Anschlagstücken 230 und 240 linear bewegbar angeordnet. Das proximale Anschlagstück 230 ist dabei an dem Greifer 210 der Vakuumpipette 250 abgewandt angeordnet. Das distale Anschlagstück 240 ist der Vakuumpipette 250 zugewandt an dem Greifer 210 angeordnet.

An dem Halter 220 können elastische Dämpfelemente 290 und 290 jeweils dem proximalen Anschlagstück 230 bzw. dem distalen Anschlagstück 240 zugewandt angeordnet sein.

Die Anschlagstücke 230 bzw. 240 können auch an dem Halter 220 ausgebildet sein, wobei die Dämpfelemente 290 bzw. 280 entsprechend an den Greifer ausgebildet sind.

Der gesamte Bewegungsbereich des Greifers 210 relativ zu dem Halter 220 beträgt in der Aufsetzrichtung A die Länge d.

Der Greifer 210 weist einen in der Aufsetzrichtung A ausgerichteten Permanentmagnet als erstes Koppelelement 260 auf. An dem Halter 220 ist ein Elektromagnet 270 als zweites Koppelelement, beispielsweise in Form einer Ringspule oder eines Linearmotors, vorgesehen, welcher mit dem Permanentmagnet 260 an dem Greifer 210 zusammenwirkt. Der Greifer 210 ist mittels einer Führungsvorrichtung (nicht gezeigt) an dem Halter 220 in der Aufsetzrichtung A geführt angeordnet.

Aus der Figur 1 ist die erfindungsgemäße Aufsetzvorrichtung in einer ersten Vorspann-Stellung dargestellt. Hierbei ist der Greifer 210 relativ zu dem Halter 220 in der Aufsetzrichtung zu dem aufzusetzenden Objekt 100 hin vorgespannt, so dass das proximale Anschlagstück 230 an dem Halter 220, bzw. an dem proximalen Dämpfelement 290 anliegt. Durch Vorbestimmen des Stroms, welcher die Ringspule bzw. den Linearmotor 270 durchfließt, ist es möglich, die Kraft vorzubestimmen, mittels welcher der Greifer 210 relativ zu dem Halter 220 in der Aufsetzvorrichtung A vorgespannt ist.

Zum Aufsetzen wird die erfindungsgemäße Aufsetzvorrichtung 200 mittels eines Antriebs, welcher den Halter 220 antreibt (nicht gezeigt) auf das Objekt 100 zu bewegt. Beim Erreichen des Objekts 100 und Aufsetzen des Greifers 210 bzw. der Vakuumpipette 250 auf das Objekt 100 bzw. des Objekts 100 auf das Substrat wird, während der Halter 220 mittels des nicht gezeigten Antriebs auf das Objekt 100 zu bewegt wird, der Greifer 210 relativ zu dem Halter entgegen der Aufsetzrichtung A bewegt, so dass die durch den Strom vorbestimmte Aufsetzkraft auf das Objekt 100 einwirkt. Die hierbei auftretende Massenträgheit ist nur von der Masse des Greifers 210 abhängig. Hierbei verringert sich die aus Figur 1 ersichtliche Länge des Bewegungsbereichs d am distalen Ende des Halters 220 auf d₁<d, wobei gleichzeitig eine entsprechende Vergrößerung des Abstands d₂ zwischen dem proximalen Anschlagstück 230 und dem Halter 220 auftritt.

Es ist somit erfindungsgemäß durch Vorspannen des Greifers 210 relativ zu dem Halter 220 in der Aufsetzrichtung möglich, sehr geringe Aufsetzkräfte mit sehr hoher Genauigkeit vorzubestimmen.

Ferner können auch gewünschte variable Kraftverläufe beim Aufsetzen erreicht werden, indem der Strom, welcher die Kraftkopplung zwischen dem Greifer 210 und dem Halter 220 bestimmt, entsprechend des gewünschten Kraftverlaufs gesteuert wird.

Bei konstant eingestelltem Strom ist die Kraftwirkung im Wesentlichen über den gesamten Bewegungsbereich d des Greifers 210 relativ zu dem Halter 220 konstant, so dass beispielsweise auch dann mit konstanter Kraft auf das Objekt 100 eingewirkt wird, wenn das Substrat, auf welches das Objekt 100 aufgesetzt wird, in der Aufsetzrichtung A bewegt wird und/oder Schwingungen ausführt. Hierdurch ist eine Erhöhung der Aufsetzgenauigkeit sowie der Zuverlässigkeit beim Aufsetzen leicht möglich.

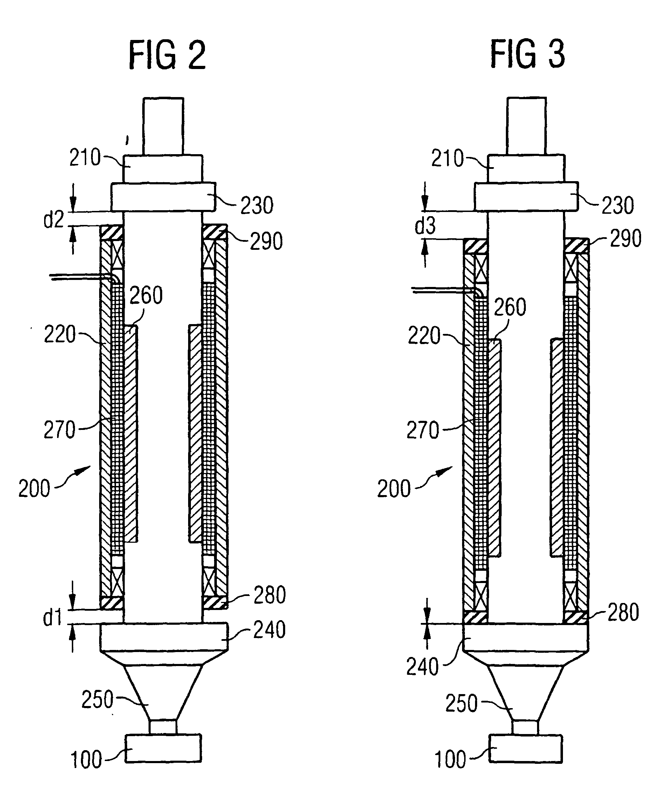

Aus Figur 3 ist die erfindungsgemäße Aufsetzvorrichtung 200 in einer zweiten Vorspann-Stellung ersichtlich, in welcher der Greifer 210 entgegen der Aufsetzrichtung A vollständig eingefedert, d. h., das distale Anschlagstück 240 gegen den distalen Endbereich des Halters 200 bzw. den distalen Dämpfer 280 des Halters 220 angelegt ist. Hierbei wird beim Bewegen des Halters 220 auf das Objekt 100 die auf das Objekt einwirkende Kraft lediglich durch die Antriebskraft bestimmt, mittels welcher der Halter 220 auf das Objekt 100 zu bewegt wird. Durch Vorbestimmen der Eigenschaften des Dämpfelements 280 ist es möglich, den Verlauf der Aufsetzkraft in dieser Betriebsweise zu beeinflussen. Hierdurch können jedoch sehr hohe Aufsetzkräfte erreicht werden, welche mittels dem Vorgenannten anhand der Figuren 1 und 2 erläuterten Verfahren nicht erreichbar sind, da aufgrund der durch die beiden Koppelelemente bestimmten Kraftwirkung zwischen dem Greifer 210 und dem Halter 220 Aufsetzkräfte nur bis zu einer bestimmten Größe möglich sind. Beispielsweise sind durch die anhand der Figuren 1 und 2 erläuterte Betriebsart bei einer Ausführungsform der erfindungsgemäßen Aufsetzvorrichtung Aufsetzkräfte zwischen 0,1 und 2 N erreichbar. Für höhere Bestückkräfte ab 2 N können mittels der anhand der Figur 3 erläuterten Betriebsweise Aufsetzkräfte zwischen 2 N und 50 N erreicht werden.

Es ist beispielsweise auch möglich, den Stromverlauf, welcher die Aufsetzkraft bestimmt, nach dem Aufsetzen des Greifers auf das Objekt oder des Objekts auf das Substrat gezielt zu verändern. Hierbei können beliebige Kraftverläufe beim Absetzen eines Objekts auf ein Substrat ermöglicht werden. Ferner ist es möglich, an dem Halter 220 und/oder an dem Greifer 210 ein Wegmess-System vorzusehen. Hierdurch kann beispielsweise ein Stillstand des Greifers 210 relativ zu dem Halter sehr schnell erfasst werden und ein Signal ausgegeben werden, welches nach dem Stillstand das Beenden des Aufsetzvorgangs signalisieren kann.

Es ist ferner auch möglich, vor dem Aufsetzen der Objekte mittels eines Kraftsensors eine Kraftmessung der Aufsetzkraft des Greifers 210 durchzuführen. Die unter Verwenden bestimmter ermittelter oder vorbestimmter Stromwerte für die elektrische Spule bzw. den Linearmotor 270 ermittelten Kraftwerte werden beispielsweise in Form elektronischer Daten abgespeichert. Durch Variieren des Stroms während der Vergleichsmessung kann die aufgrund eines Stroms vorbestimmte Aufsetzkraft vorab genau ermittelt und abgespeichert werden.

## Patentansprüche

1. Aufsetzvorrichtung zum Aufsetzen von Objekten auf Substrate, mit einem in einer Aufsetzrichtung (A) bewegbaren Halter (220), einem zwischen zwei Enden eines Bewegungsbereiches (d) an dem Halter (220) in Aufsetzrichtung (A) linear bewegbar geführten Greifer(210), von welchem die Objekte (100) aufnehmbar sind und welcher durch Bewegen des Halters (220) auf ein Substrat zu bewegbar ist, wobei
• an dem Greifer (210) ein erstes Koppelelement (260) vorgesehen ist,
• an dem Halter (220) ein zweites Koppelelement(270) vorgesehen ist, und
• zwischen dem ersten Koppelelement (260) und dem zweiten Koppelelement (270) eine von einem elektrischen und/oder magnetischen Feld erzeugte steuerbare elektrische und/oder magnetische Kraft wirkt, von welcher der Greifer (210) in der Aufsetzrichtung (A) gegen eines der Enden des Bewegungsbereichs (d) vorgespannt ist.

2. Aufsetzvorrichtung nach Anspruch 1, wobei
• das erste Koppelelement (260) eine von einem elektrischen Strom durchflossene Spule ist,
• das zweite Koppelelement (270) ein Permanentmagnet ist, und
• durch Steuern der Stromstärke des Stroms die beim Aufsetzen des Objekts (100) auf das Substrat wirkende Aufsetzkraft steuerbar ist.

3. Aufsetzvorrichtung nach Anspruch 1, wobei
• das erste Koppelelement (260) ein Permanentmagnet ist,
• das zweite Koppelelement (270) eine von einem elektrischen Strom durchflossene Spule ist, und
• durch Steuern der Stromstärke des Stroms die beim Aufsetzen des Objekts (100) auf das Substrat wirkende Aufsetzkraft steuerbar ist.

4. Aufsetzvorrichtung nach Anspruch 1, wobei
• das erste Koppelelement (260) eine von einem ersten Strom durchflossene erste Spule ist,
• das zweite Koppelelement (270) eine von einem zweiten Strom durchflossene zweite Spule ist, und
• durch Steuern der Stromstärke des ersten Stroms und/oder der Stromstärke des zweiten Stroms die beim Aufsetzen des Objekts (100) auf das Substrat wirkende Aufsetzkraft steuerbar ist.

5. Aufsetzvorrichtung nach einem der Ansprüche 2 bis 4, wobei
• von dem ersten Koppelelement (260) und dem zweiten Koppelelement (270) ein Linearmotor gebildet ist.

6. Aufsetzvorrichtung nach einem der Ansprüche 1 bis 5, wobei
• der Halter (220) und der Greifer (210) in der Aufsetzrichtung (A) koaxial zueinander angeordnet sind.

7. Aufsetzvorrichtung nach einem der vorangegangenen Ansprüche, wobei
• an jedem der Enden des Bewegungsbereichs jeweils ein Anschlagstück (230, 240) angebracht ist, so dass der Greifer (210) mittels einer Führungsvorrichtung zwischen den Anschlagstücken (230, 240) an dem Halter (220) bewegbar geführt ist.

8. Aufsetzvorrichtung nach Anspruch 7, wobei
• an jedem Anschlagstück (230, 240) und/oder an jedem Endbereich der Führungsvorrichtung jeweils ein Dämpfelement (280, 290) zwischen dem Anschlagstück (230, 240) und der Führungsvorrichtung angeordnet ist.

9. Aufsetzvorrichtung nach einem der vorgenannten Ansprüche, wobei
• jede Spule bzw. jeder Permanentmagnet hohlzylinderartig ausgebildet ist.

10. Verfahren zum Aufsetzen von Objekten auf Substrate mittels eines Greifers (210), wobei ein Halter (220) in einer Aufsetzrichtung (A) bewegt wird, der Greifer (210) mittels einer Führungsvorrichtung zwischen zwei Enden eines Bewegungsbereiches (d) in der Aufsetzrichtung (A) linear an dem Halter (220) derart geführt ist, daß der Greifer (210) in der Aufsetzrichtung (A) von dem Halter (220) vorragt, und wobei der Greifer (210) in der Aufsetzrichtung (A) gegen eines der beiden Enden des Bewegungsbereiches (d) vorspannbar ist, wodurch eine vorbestimmte Aufsetzkraft festgelegt ist, welche der Greifer (210) beim Aufsetzen des Objekts (100) ausübt, wobei
• die Vorspannung des Greifers (210) gegenüber dem Halter (220) durch ein steuerbares magnetisches und/oder elektrisches Feld bewirkt wird,
• die Größe der Vorspannung durch Steuern des magnetischen und/oder elektrischen Felds entsprechend einem vorbestimmten Wert eingestellt wird,
• der Halter (220) zum Aufsetzen des Greifers (210) in der Aufsetzrichtung (A) auf das Objekt(100) bzw. das Substrat zu bewegt wird,
• der Greifer (210) beim Aufsetzen auf das Objekt (100) bzw. das Substrat die vorbestimmte Aufsetzkraft auf das Objekt (100) ausübt, während er relativ zu dem Halter (220) entgegen der Aufsetzrichtung (A) bewegt wird, bis der Halter (220) angehalten wird.

11. Verfahren nach Anspruch 10, wobei
• das steuerbare magnetische und/oder elektrische Feld mittels jeweils an dem Halter (220) und an dem Greifer (210) angebrachten Koppelelementen (260, 270) erzeugt wird,
• als Koppelelemente (260, 270) Permanentmagnete und/oder stromdurchflossene Spulen verwendet werden, und
• als mindestens eines der Koppelelemente (260, 270) eine stromdurchflossene Spule verwendet wird.

12. Verfahren nach einem der Ansprüche 10 oder 11, wobei
• die Aufsetzkraft abhängig von den Eigenschaften des Objekts (100) selektiv vorbestimmt wird.

13. Verfahren nach Anspruch 12, wobei
• vor dem Aufsetzen auf das Objekt (100) die Führungsvorrichtung des Greifers (210) an ein an dem proximalen Ende des Bewegungsbereiches (d) ausgebildetes Anschlagstück (230) angelegt wird, und
• die Aufsetzkraft des Greifers (210) auf das Objekt (100) vorbestimmt wird, indem das Anlegen mit einer der gewünschten Aufsetzkraft entsprechenden Kraft durchgeführt wird.

14. Verfahren nach Anspruch 12, wobei
• vor dem Aufsetzen auf das Objekt (100) die Führungsvorrichtung des Greifers (210) an ein an dem distalen Ende des Bewegungsbereiches (d) an dem Halter (220) ausgebildetes Anschlagstück (240) angelegt wird, und
• die Aufsetzkraft durch Vorbestimmen der Antriebskraft festgelegt wird, mit welcher der Halter (220) auf das Objekt (10) zu bewegt wird.

15. Verfahren zum Abheben von Objekten (100) von Substraten mittels eines Greifers (210), wobei der Greifer (210) mittels einer Führungseinrichtung zwischen zwei Enden eines Bewegungsbereiches (d) in einer Abheberichtung (A) linear derart an dem Halter (220) bewegbar geführt ist, dass der Greifer (210) entgegen der Abheberichtung (A) von dem Halter (220) vorragt, wobei
• der Greifer (210) vor dem Abheben auf den Halter (220) zu bewegt wird,
• zum Abheben des Objektes (100) von dem Substrat der Halter (220) in der Abheberichtung (A) von dem Substrat weg bewegt wird,
• während des Abhebens der Greifer (210)relativ zu dem Halter (220) entgegen der Abheberichtung (A) bewegt wird, wodurch an dem Objekt (100) auftretende Beschleunigungen egalisiert werden.

## Claims

1. Placing device for placing objects on substrates, with a moving holder (220), a gripper (210) having a linear guided movement in a placing direction (A) between two ends of a range of movement (d) on the holder (220), by which gripper (210) the objects (100) can be lifted and moved to a substrate by moving the holder (220), with
• a first coupling element (260) being provided on the holder (210),
• a second coupling element (270) being provided on the gripper (220) and
• an electrical and/or magnetic force generated by an electrical and/or magnetic field acting between the first coupling element (260) and second coupling element (270), so that the gripper (210) is pretensioned in the placing direction (A) against one of the ends of the range of movement (d).

2. Placing device in accordance with Claim 1, with
• the first coupling element (260) being a coil through which an electric current flows,
• the second coupling element (270) being a permanent magnet and
• the placing force acting on the substrate when the object (100) is being placed being controlled by controlling the strength of the current.

3. Placing device in accordance with Claim 1, with
• the first coupling element (260) being a permanent magnet,
• the second coupling element (270) being a coil through which an electric current flows and
• the placing force acting on the substrate when the object (100) is being placed being controlled by controlling the strength of the current.

4. Placing device in accordance with Claim 1, with
• the first coupling element (260) being a first coil through which a first current flows,
• the second coupling element (270) being a second coil through which a second current flows and
• the placing force acting on the substrate when the object (100) is being placed being controlled by controlling the strength of the current and/or the strength of the second current.

5. Placing device in accordance with one of Claims 2 to 4, with
• the first coupling element (260) and the second coupling element (270) forming a linear motor.

6. Placing device in accordance with one of Claims 1 to 5, with
• the holder (220) and the gripper (210) being arranged coaxially relative to each other in the placing direction (A).

7. Placing device in accordance with one of the preceding claims, with
• a stop piece (230, 240) being fitted at each end of the range of movement, so that the gripper (210) is provided with a guided movement between the stop pieces (230, 240) on the holder (220) by means of a guiding device.

8. Placing device in accordance with Claim 7, with
• a damping element (280, 290) being arranged at each stop piece (230, 240) and/or at each end area of the guiding device between the stop piece (230, 240) and the guiding device.

9. Placing device in accordance with one of the preceding claims, with
• each coil or each permanent magnet being designed in the form of a hollow cylinder.

10. Method for placing objects on substrates by means of a gripper (210), with a holder (220) moving in a placing device (A), the gripper (210) being linearly guided on the holder (220) in the placing direction (A) by means of a guiding device between two ends of a range of movement (d), with the gripper (210) projecting from the holder (220) in the placing direction (A) and with the gripper (210) being pretensioned against one of the two ends of the range of movement (d), whereby a predetermined placing force is specified that acts on the gripper (210) when placing the object (100) with
• the pretension of the gripper (210) relative to the holder (220) being effected by a controlled magnetic and/or electrical field,
• the magnitude of the pretension being set corresponding to a preset value by controlling the magnetic and/or electrical field,
• the holder (220) being moved in the placing direction (A) onto the object (100) or substrate for placing the gripper (210),
• the gripper (210) exerting a predetermined placing force on the object (100) when being placed on the object (100) or on the substrate, while it is moved against the placing direction (A) relative to the holder (220) until the holder (220) is stopped.

11. Method in accordance with Claim 10, with
• the controlled magnetic and/or electrical field being generated by coupling elements (260, 270) mounted on the holder (220) and gripper (210) in each case,
• permanent magnets and/or coils through which currents flow being used as coupling elements (260, 270) and
• a coil through which current flows being used as at least one of the coupling elements (260, 270).

12. Method in accordance with one of Claims 10 or 11, with
• the placing force being selectively predetermined relative to the properties of the object (100).

13. Method in accordance with Claim 12, with
• the guiding device of the gripper (210) being placed against a stop piece (230) formed at the proximal end of the range of movement (d) before the placing on the object (100) and
• the placing force of the gripper (210) on the object (100) being predetermined, in that the application is carried out using a force corresponding to the required placing force.

14. Method in accordance with Claim 12, with
• the guiding device of the gripper (210) being placed against a stop piece (240) formed on the holder (220) at the distal end of the range of movement (d) before the placing of the object (100) and
• the placing force with which the holder (220) is moved onto the object (100) being specified by predetermining the drive force.

15. Method for lifting the objects (100) from substrates by means of a gripper (210), with the gripper (210) having a linearly guided movement in a lifting direction (A) on the holder (220) by means of a guiding device between the two ends of a range of movement (d), with the gripper (210) projecting from the holder (220) against the lifting direction (A), with
• the gripper (210) being moved to the distal end of the range of movement (d) relative to the holder (220) before lifting,
• the holder (220) being moved from the substrate in the lifting direction (A) to lift the object (100) from the substrate,
• with the gripper (210) being moved to the proximal end of the range of movement (d) relative to the holder (220) when lifting, with the acceleration occurring on the object (100) being thus equalized.

## Revendications

1. Dispositif de mise en place pour la mise en place d'objets sur des substrats, qui présente un dispositif de maintien (220) qui peut être déplacé dans une direction de mise en place (A), un dispositif de saisie (210) guidé à déplacement linéaire entre deux extrémités d'une plage de déplacement (d) sur le dispositif de maintien (220) dans la direction de mise en place (A), qui peut saisir les objets (100) et qui peut être déplacé vers un substrat par déplacement du dispositif de maintien (220), dans lequel :
• un premier élément d'accouplement (260) est prévu sur le dispositif de saisie (210),
• un deuxième élément d'accouplement (270) est prévu sur le dispositif de maintien (220) et
• une force électrique et/ou magnétique contrôlable créée par un champ électrique et/ou un champ magnétique agit entre le premier élément d'accouplement (260) et le deuxième élément d'accouplement (270) et précontraint le dispositif de saisie (210) dans la direction de mise en place (A) contre une des extrémités de la plage de déplacement (d).

2. Dispositif de mise en place selon la revendication 1, dans lequel :
• le premier élément d'accouplement (260) est une bobine traversée par un courant électrique,
• le deuxième élément d'accouplement (270) est un aimant permanent et
• la force de mise en place qui agit lors de la mise en place de l'objet (100) sur le substrat peut être contrôlée par contrôle de l'intensité du courant.

3. Dispositif de mise en place selon la revendication 1, dans lequel :
• le premier élément d'accouplement (260) est un aimant permanent,
• le deuxième élément d'accouplement (270) est une bobine traversée par un courant électrique et
• la force de mise en place qui agit lors de la mise en place de l'objet (100) sur le substrat peut être contrôlée par contrôle de l'intensité du courant.

4. Dispositif de mise en place selon la revendication 1, dans lequel :
• le premier élément d'accouplement (260) est une première bobine traversée par un premier courant,
• le deuxième élément d'accouplement (270) est une deuxième bobine traversée par un deuxième courant et
• la force de mise en place qui agit lors de la mise en place de l'objet (100) sur le substrat peut être contrôlée par contrôle de l'intensité du premier courant et/ou de l'intensité du deuxième courant.

5. Dispositif de mise en place selon l'une des revendications 2 à 4, dans lequel :
• un moteur linéaire est formé par le premier élément d'accouplement (260) et le deuxième élément d'accouplement (270).

6. Dispositif de mise en place selon l'une des revendications 1 à 5, dans lequel :
• le dispositif de maintien (220) et le dispositif de saisie (210) sont disposés coaxialement l'un par rapport à l'autre dans la direction de mise en place (A).

7. Dispositif de mise en place selon l'une des revendications précédentes, dans lequel :
• à chacune des extrémités de la plage de déplacement est installée une pièce de butée (230, 240) respective, de telle sorte qu'au moyen d'un dispositif de guidage, le dispositif de saisie (210) est guidé à déplacement sur le dispositif de maintien (220) entre les deux pièces de butée (230, 240).

8. Dispositif de mise en place selon la revendication 7, dans lequel :
• sur chaque pièce de butée (230, 240) et/ou sur chaque zone d'extrémité du dispositif de guidage, un élément d'amortissement (280, 290) respectif est disposé entre la pièce de butée (230, 240) et le dispositif de guidage.

9. Dispositif de mise en place selon l'une des revendications précédentes, dans lequel :
• chaque bobine ou chaque aimant permanent sont configurés en forme de cylindre creux.

10. Procédé de mise en place d'objets sur des substrats au moyen d'un dispositif de saisie (210), un dispositif de maintien (220) étant déplacé dans une direction de mise en place (A), le dispositif de saisie (210) étant guidé linéairement au moyen d'un dispositif de guidage sur le dispositif de maintien (220) entre deux extrémités d'une plage de déplacement (d) dans la direction de mise en place (A), de telle sorte que le dispositif de saisie (210) déborde du dispositif de maintien (220) dans la direction de mise en place (A), le dispositif de saisie (210) pouvant être précontraint dans la direction de mise en place (A) contre l'une des deux extrémités de la plage de déplacement (d), ce qui définit une force de mise en place prédéterminée que le dispositif de saisie (210) exerce lorsqu'il met en place l'objet (100), dans lequel :
• la précontrainte du dispositif de saisie (210) par rapport au dispositif de maintien (220) est obtenue par un champ magnétique et/ou électrique contrôlable,
• la valeur de la précontrainte est réglée par contrôle du champ magnétique et/ou du champ électrique en correspondance à une valeur prédéterminée,
• le dispositif de maintien (220) est déplacé vers l'objet (100) ou le substrat pour mettre en place le dispositif de saisie (210) dans la direction de mise en place (A),
• lors de la mise en place sur l'objet (100) resp. sur le substrat, le dispositif de saisie (210) exerce la force de mise en place prédéterminée sur l'objet (100) en étant déplacé par rapport au dispositif de maintien (220) en opposition à la direction de mise en place (A) jusqu'à ce que le dispositif de maintien (220) soit arrêté.

11. Procédé selon la revendication 10, dans lequel :
• le champ magnétique et/ou le champ électrique contrôlable sont créés au moyen d'éléments d'accouplement (260, 270) installés respectivement sur le dispositif de maintien (220) et sur le dispositif de saisie (210),
• comme éléments d'accouplement (260, 270), on utilise des aimants permanents et/ou des bobines traversées par du courant et
• pour au moins l'un des éléments d'accouplement (260, 270), on utilise une bobine traversée par un courant.

12. Procédé selon l'une des revendications 10 ou 11, dans lequel :
• la force de mise en place est prédéterminée de manière sélective en fonction des propriétés de l'objet (100).

13. Procédé selon la revendication 12, dans lequel :
• avant la mise en place sur l'objet (100), le dispositif de guidage du dispositif de saisie (210) est appliqué contre une pièce de butée (230) formée à l'extrémité proximale de la plage de déplacement (d) et
• la force de mise en place exercée par le dispositif de saisie (210) sur l'objet (100) est prédéterminée en effectuant l'application avec une force qui correspond à la force de mise en place souhaitée.

14. Procédé selon la revendication 12, dans lequel :
• avant la mise en place sur l'objet (100), le dispositif de guidage du dispositif de saisie (210) est appliqué contre une pièce de butée (240) formée sur le dispositif de maintien (220) à l'extrémité distale de la plage de déplacement (d) et
• la force de mise en place est définie en prédéterminant la force d'entraînement par laquelle le dispositif de maintien (220) est déplacé vers l'objet (10).

15. Procédé d'enlèvement d'objets (100) de substrats au moyen d'un dispositif de saisie (210), dans lequel le dispositif de saisie (210) est guidé à déplacement linéaire au moyen d'un dispositif de guidage sur le dispositif de maintien (220) entre deux extrémités d'une plage de déplacement (d) dans la direction d'enlèvement (A) de telle sorte que le dispositif de saisie (210) déborde du dispositif de maintien (220) dans la direction opposée à la direction d'enlèvement (A), dans lequel :
• avant l'enlèvement, le dispositif de saisie (210) est déplacé en direction du dispositif de maintien (220),
• pour enlever l'objet (100) du substrat, le dispositif de maintien (220) est éloigné du substrat dans la direction d'enlèvement (A) et
• pendant l'enlèvement, le dispositif de saisie (210) est déplacé par rapport au dispositif de maintien (220) en opposition à la direction d'enlèvement (A), ce qui égalise les accélérations se produisant sur l'objet (100).
